# EUROPÄISCHE PATENTANMELDUNG

(11) **EP 2 408 009 A2**
(43) Veröffentlichungstag der Anmeldung: **18.01.2012**
(21) Anmeldenummer: 11005569.6
(22) Anmeldetag: 07.07.2011
(51) Int. Cl.: H01L 23/62, H01L 27/146, H01L 31/115

(54) **Halbleiterbauelement, insbesondere Strahlungsdetektor, mit einem integrierten Überspannungsschutz**

(30) Priorität: 14.07.2010 DE 102010027128
(71) Anmelder: PNSensor GmbH, 80803 München (DE)
(72) Erfinder: Lutz, Gerhard, 81739 München (DE); Soltau, Heike, 80803 München (DE)
(74) Vertreter: Hertz, Oliver

(57) **Zusammenfassung**

Die Erfindung betrifft ein Halbleiterbauelement, insbesondere einen Strahlungsdetektor (1) zur Detektion von Strahlung, mit einem Halbleitersubstrat (2), in dem die zu detektierende Strahlung Signalladungsträger generiert, und einem Überspannungsschutz zur Vermeidung von elektrischen Überspannungen. Es wird vorgeschlagen, dass der Überspannungsschutz (6) in das Halbleitersubstrat (2) integriert wird.

## Beschreibung

Die Erfindung betrifft ein Halbleiterbauelement, insbesondere einen Strahlungsdetektor zur Detektion von Strahlung, wobei der Strahlungsdetektor als Halbleiterdetektor ausgebildet ist.

Derartige Strahlungsdetektoren sind an sich bekannt und beispielsweise in DE 10 2007 017 640 B3, DE 102 13 812 A1, DE 10 2007 029 898 B3 und DE 10 2004 004 283 A1 beschrieben. Bei derartigen Halbleiterdetektoren erzeugt die zu detektierende Strahlung in einem Halbleitersubstrat Signalladungsträger, die somit ein Maß für die zu detektierende Strahlung bilden und von einer Auslesestruktur (z.B. einem DEPFET - Depleted Field Effect Transistor) ausgelesen werden. Problematisch hierbei ist die Tatsache, dass derartige Halbleiterdetektoren oftmals in der Nähe von Hochspannung führenden Geräten betrieben werden, wie beispielsweise Röntgengeräten oder Elektronenquellen. Dieses kann zu Funkenüberschlägen führen, die dann auf direkte oder indirekte Weise zu Überspannungen an den Anschlusskontakten des Halbleiterdetektors führen. Als Folge dieser Überspannungen kann es zur dauerhaften Verschlechterung der Detektoreigenschaften oder auch zur vollständigen Zerstörung des Halbleiterdetektors kommen. Besonders empfindlich sind hierbei Leitungsüberführungen innerhalb des Detektors, die durch Isolatoren (z.B. Siliziumdioxid) getrennt sind, wobei derartige Leitungsüberführungen beispielsweise in DE 102 13 812 A1 beschrieben sind.

Zur Vermeidung derartiger Überspannungen ist herkömmlicherweise ein Überspannungsschutz vorgesehen, der aus diskreten Bauelementen besteht und an die Anschlusskontakte des Halbleiterdetektors angeschlossen ist. Beispielsweise ist es bekannt, die herkömmlichen Halbleiterdetektoren mit einer Schutzschaltung aus einem Widerstand und einer Zener-Diode zu beschalten, um Überspannungen zu vermeiden.

Nachteilig an diesem herkömmlichen Überspannungsschutz ist jedoch die Tatsache, dass eine separate Schutzschaltung erforderlich ist, die aus diskreten Bauelementen aufgebaut ist und dann mit dem Halbleiterdetektor verbunden werden muss.

Der Erfindung liegt deshalb die Aufgabe zugrunde, eine bessere Möglichkeit für einen Überspannungsschutz zu schaffen.

Diese Aufgabe wird durch einen erfindungsgemäßen Strahlungsdetektor mit einem integrierten Überspannungsschutz gelöst.

Die Erfindung umfasst die allgemeine technische Lehre, den Überspannungsschutz nicht - wie beim Stand der Technik - als separate Schutzschaltung aus diskreten Bauelementen aufzubauen, sondern stattdessen in das Halbleitersubstrat zu integrieren.

Zum einen bietet dies den Vorteil, dass keine separate Schutzschaltung erforderlich ist, die aus diskreten Bauelementen besteht. Es ist jedoch zu erwähnen, dass die Erfindung nicht nur Schutz beansprucht für einen Strahlungsdetektor, bei dem der Überspannungsschutz vollständig in das Halbleitersubstrat integriert ist. Es ist vielmehr auch möglich, dass der erfindungsgemäße Strahlungsdetektor zusätzlich zu dem integrierten Überspannungsschutz noch eine separate Schutzschaltung aufweist.

Zum anderen ist die Integration des Überspannungsschutzes in das Halbleitersubstrat aber auch fertigungstechnisch vorteilhaft, da die Schutzschaltung und der Strahlungsdetektor dann in einem einheitlichen Fertigungsprozess hergestellt werden können.

In einem bevorzugten Ausführungsbeispiel der Erfindung weist der Überspannungsschutz ein Schutzelement (z.B. Zener-Diode, Avalanche-Diode, Punch-Through-Struktur) mit einer nicht-linearen Strom-Spannungs-Kennlinie mit einer bestimmten Durchbruchspannung auf, wobei das Schutzelement unterhalb der Durchbruchspannung im Wesentlichen sperrt und oberhalb der Durchbruchspannung im Wesentlichen leitet. Falls nun im Betrieb des Strahlungsdetektors die zu begrenzende elektrische Spannung so weit ansteigt, dass die Durchbruchspannung des Schutzelements erreicht wird, so verhindert der Spannungsdurchbruch in dem Schutzelement ein weiteres Ansteigen der zu begrenzenden elektrischen Spannung.

Hierbei ist die Strom-Spannungs-Kennlinie des Schutzelements vorzugsweise in dem Sinne symmetrisch, dass das Schutzelement sowohl eine positive Durchbruchspannung als auch eine negative Durchbruchspannung aufweist, so dass die zu begrenzende elektrische Spannung unabhängig von ihrer Polarität begrenzt wird. Hierbei können die positive und die negative Durchbruchspannung gleich groß sein. Es besteht jedoch auch die Möglichkeit, dass sich die positive Durchbruchspannung von der negativen Durchbruchspannung betragsmäßig unterscheidet.

In dem bevorzugten Ausführungsbeispiel der Erfindung weist der Strahlungsdetektor einen ersten Anschlusskontakt auf, an dem eine zu begrenzende externe Spannung anliegt. Darüber hinaus weist der Strahlungsdetektor vorzugsweise einen zweiten Anschlusskontakt auf, an dem eine spannungsbegrenzte interne Spannung bereitgestellt wird, wobei der Überspannungsschutz die interne Spannung vor einer Überspannung der externen Spannung schützt. Darüber hinaus weist der erfindungsgemäße Strahlungsdetektor vorzugsweise auch einen dritten Anschlusskontakt auf, um ein Referenzpotential bereitzustellen, wobei der Überspannungsschutz die zu begrenzende externe Spannung gegenüber dem Referenzpotential begrenzt. Die maximal zulässige Spannung lässt sich also einstellen, indem das elektrische Referenzpotential an dem dritten Anschlusskontakt entsprechend eingestellt wird. Hierbei ist der Überspannungsschutz vorzugsweise zwischen den zweiten Anschlusskontakt für die interne Spannung und den dritten Anschlusskontakt für die Referenzspannung geschaltet.

Darüber hinaus weist der Überspannungsschutz vorzugsweise einen Widerstand auf, der zwischen den ersten Anschlusskontakt für die externe Spannung und den zweiten Anschlusskontakt für die interne Spannung geschaltet ist, so dass ein Teil der Überspannung über dem Widerstand abfällt. Hierbei ist zu erwähnen, dass der Widerstand vorzugsweise in das Halbleitersubstrat integriert ist, jedoch ist es grundsätzlich auch möglich, den Widerstand als separates diskretes Bauelement auszubilden. Bei einer Integration des Widerstands in das Halbleitersubstrat ist es jedoch vorteilhaft, wenn der Widerstand in dem Halbleitersubstrat mindestens teilweise spiralförmig oder mäanderförmig verläuft, um einen möglichst langen Strompfad in dem Widerstand mit einem entsprechend hohen Widerstandswert zu realisieren.

In dem bevorzugten Ausführungsbeispiel der Erfindung weist der integrierte Überspannungsschutz eine Punch-Through-Struktur auf, die in das Halbleitersubstrat integriert ist. Derartige Punch-Through-Strukturen sind an sich aus dem Stand der Technik bekannt und beispielsweise in Gerhard Lutz: "Semiconductor Radiaton Detectors", Springer-Verlag, 2. Auflage 2001, Seiten 213-217 beschrieben, so dass an dieser Stelle auf eine detaillierte Beschreibung des Aufbaus und der Funktionsweise von Punch-Through-Strukturen verzichtet werden kann. An dieser Stelle ist lediglich zu erwähnen, dass derartige Punch-Through-Strukturen eine nicht-lineare Strom-Spannungs-Kennlinie mit einer Durchbruchspannung aufweisen und sich deshalb im Rahmen der Erfindung als spannungsbegrenzendes Schutzelement eignen.

Es besteht jedoch im Rahmen der Erfindung alternativ auch die Möglichkeit, ein anderes spannungsbegrenzendes Schutzelement in das Halbleitersubstrat zu integrieren, wie beispielsweise eine Zener-Diode, eine Suppressor-Diode oder eine Avalanche-Diode, um nur einige Beispiele zu nennen.

Hinsichtlich der Anordnung der Punch-Through-Struktur in dem Halbleitersubstrat bestehen im Rahmen der Erfindung verschiedene Möglichkeiten, die im Folgenden kurz beschrieben werden.

In einer Variante der Erfindung ist die Punch-Through-Struktur in dem Halbleitersubstrat vertikal angeordnet und erstreckt sich zwischen gegenüberliegenden Oberflächen des Halbleitersubstrats. Dies bedeutet, dass der Stromfluss in der Punch-Through-Struktur bei einem Spannungsdurchschlag zwischen den gegenüberliegenden Oberflächen des Halbleitersubstrats erfolgt, d.h. in vertikaler Richtung.

In einer anderen Variante der Erfindung ist die Punch-Through-Struktur in dem Halbleitersubstrat dagegen lateral angeordnet und erstreckt sich entlang der selben Oberfläche des Halbleitersubstrats. Hierbei erfolgt der Stromfluss in der Punch-Through-Struktur bei einem Spannungsdurchschlag also in lateraler Richtung, d.h. im Wesentlichen parallel zu der Oberfläche des Halbleitersubstrats.

Hinsichtlich der halbleitertechnischen Realisierung der Punch-Through-Struktur ist zu erwähnen, dass das Halbleitersubstrat entsprechend einem ersten Dotierungstyp (z.B. n-Dotierung) dotiert ist, während die Punch-Through-Struktur zwei dotierte Gebiete aufweist, die entsprechend einem zweiten Dotierungstyp (z.B. p-Dotierung) dotiert und in das Halbleitersubstrat eingelassen sind, wobei die beiden dotierten Gebiete der Punch-Through-Struktur voneinander beabstandet sind.

Darüber hinaus weist der erfindungsgemäße Strahlungsdetektor vorzugsweise noch ein drittes dotiertes Gebiet auf, das entsprechend dem zweiten Dotierungstyp (z.B. p-Dotierung) dotiert und in das Halbleitersubstrat eingelassen ist, wobei dieses dritte dotierte Gebiet von den beiden anderen dotierten Gebieten der Punch-Through-Struktur beabstandet ist und mit einem ersten Anschlusskontakt verbunden ist, der zur Zuführung der zu begrenzenden externen Spannung dient. Vorzugsweise ist das dritte dotierte Gebiet für den ersten Anschlusskontakt für die externe Spannung an der selben Oberfläche des Halbleitersubstrats angeordnet wie das zweite dotierte Gebiet der Punch-Through-Struktur. Das erste dotierte Gebiet der Punch-Through-Struktur ist vorzugsweise mit dem dritten Anschlusskontakt verbunden, an dem das Referenzpotential zugeführt wird. Das zweite dotierte Gebiet der Punch-Through-Struktur ist dagegen vorzugsweise mit dem zweiten Anschlusskontakt verbunden, an dem die spannungsbegrenzte interne Spannung bereitgestellt wird.

In dem bevorzugten Ausführungsbeispiel der Erfindung weist das Halbleitersubstrat an der Oberfläche mit dem ersten Anschlusskontakt für die externe Spannung eine Oxidschicht auf, die als Isolationsschicht dient.

In einer Variante der Erfindung spart diese Oxidschicht den Bereich des ersten Anschlusskontakts für die externe Spannung und/oder den Bereich des integrierten Widerstands aus, um eine Schädigung der Oxidschicht durch die externe Spannung zu vermeiden.

In einer anderen Variante der Erfindung erstreckt sich die Oxidschicht dagegen auch in den Bereich des ersten Anschlusskontakts für die externe Spannung und/oder in den Bereich des integrierten Widerstands, wobei der erste Anschlusskontakt für die externe Spannung das in das Halbleitersubstrat eingelassene dritte dotierte Gebiet kontaktiert, insbesondere durch die Oxidschicht hindurch.

Die Punch-Through-Spannung der erfindungsgemäßen Punch-Through-Struktur wird bei einer lateralen Punch-Through-Struktur durch den Abstand zwischen den beiden dotierten Gebieten der Punch-Through-Struktur und durch die Dotierungsstärke in dem dazwischen liegenden Bereich des Halbleitersubstrats bestimmt, wobei eine Vergrößerung der Dotierungsstärke und eine Vergrößerung des Abstandes zu einer entsprechenden Erhöhung der Punch-Through-Spannung führen. Es besteht deshalb im Rahmen der Erfindung die Möglichkeit, die Dotierungsstärke in der Punch-Through-Struktur zwischen den dotierten Bereichen gezielt (z.B. durch eine Phosphor-Implantation) zu erhöhen, um dadurch eine höhere Punch-Through-Spannung zu erreichen.

Hierbei ist jedoch zu beachten, dass es vor Erreichen der Punch-Through-Spannung zu einem Avalanche-Durchbruch kommen kann. In einer Variante der Erfindung ist deshalb zur Erreichung höherer Punch-Through-Spannungen vorgesehen, mehrere Punch-Through-Strukturen elektrisch hintereinander zu schalten.

Vorzugsweise sind die verschiedenen Punch-Through-Strukturen hierbei jeweils ringförmig ausgebildet und liegen im Wesentliche konzentrisch ineinander. Es ist jedoch in diesem Sinne nicht erforderlich, dass die ringförmigen Punch-Through-Strukturen rund sind. In dem bevorzugten Ausführungsbeispiel sind die einzelnen Punch-Through-Strukturen vielmehr rechteckig. Darüber hinaus erfordert der vorstehend erwähnte Begriff der Konzentrizität im Rahmen der Erfindung nicht, dass die verschiedenen ringförmigen Punch-Through-Strukturen exakt denselben Mittelpunkt aufweisen. Es reicht in diesem Sinne vielmehr aus, wenn die einzelnen ringförmigen Punch-Through-Strukturen ineinander liegen.

Alternativ besteht im Rahmen der Erfindung auch die Möglichkeit, dass die einzelnen Punch-Through-Strukturen linear geformt und nebeneinander angeordnet sind.

Ferner ist zu erwähnen, dass der Überspannungsschutz (z.B. die Punch-Through-Struktur) in dem Halbleitersubstrat von einer Tiefenimplantation unterlegt sein kann, wobei die Implantation den gleichen Dotierungstyp aufweist wie das Halbleitersubstrat. Bei einem n-dotierten Halbleitersubstrat ist die Unterlegung der Punch-Through-Struktur also stark n-dotiert.

Darüber hinaus ist zu erwähnen, dass der erste Dotierungstyp vorzugsweise eine n-Dotierung ist, während der zweite Dotierungstyp vorzugsweise eine p-Dotierung ist. Es ist jedoch grundsätzlich auch möglich, dass es sich bei dem ersten Dotierungstyp um eine p-Dotierung handelt, während der zweite Dotierungstyp eine n-Dotierung ist.

Ferner besteht im Rahmen der Erfindung die Möglichkeit, dass in die Oberseite des Halbleitersubstrats eine dotierte Wanne eingelassen ist, in der dann der Überspannungsschutz realisiert ist. Beispielsweise kann das Halbleitersubstrat p-dotiert sein, wobei in das p-dotierte Halbleitersubstrat an der Oberseite eine n-dotierte Wanne eingelassen ist, in der dann die p-dotierten Gebiete der Punch-Through-Struktur angeordnet sind. Umgekehrt besteht aber auch die Möglichkeit, dass das Halbleitersubstrat n-dotiert sein, wobei in das n-dotierte Halbleitersubstrat an der Oberseite eine p-dotierte Wanne eingelassen ist, in der dann die n-dotierten Gebiete der Punch-Through-Struktur angeordnet sind.

Schließlich ist noch zu erwähnen, dass der erfindungsgemäße Gedanke der Integration eines Überspannungsschutzes in ein Halbleitersubstrat nicht auf Strahlungsdetektoren beschränkt ist. Vielmehr beansprucht die Erfindung auch Schutz für andere Halbleiterbauelemente, bei denen ein Überspannungsschutz in ein Halbleitersubstrat integriert ist.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine schematische Querschnittsansicht durch einen erfindungsgemäßen Strahlungsdetektor mit einer lateralen Punch-Through-Struktur zur Spannungsbegrenzung,
- Figur 2: eine Abwandlung des Ausführungsbeispiels gemäß Figur 1, wobei die Punch-Through-Struktur in dem Halbleitersubstrat vertikal angeordnet ist,
- Figur 3: eine schematische Darstellung eines weiteren Ausführungsbeispiels der Erfindung mit mehreren hintereinander geschalteten ringförmigen Punch-Through-Strukturen und einem spiralförmig gewickelten integrierten Widerstand,
- Figur 4: eine qualitative Darstellung der Strom-Spannungs-Kennlinie der Punch-Through-Struktur, sowie
- Figur 5: ein vereinfachtes Ersatzschaltbild des erfindungs-gemäßen Überspannungsschutzes mit einer Suppressor-Diode als Schutzelement.

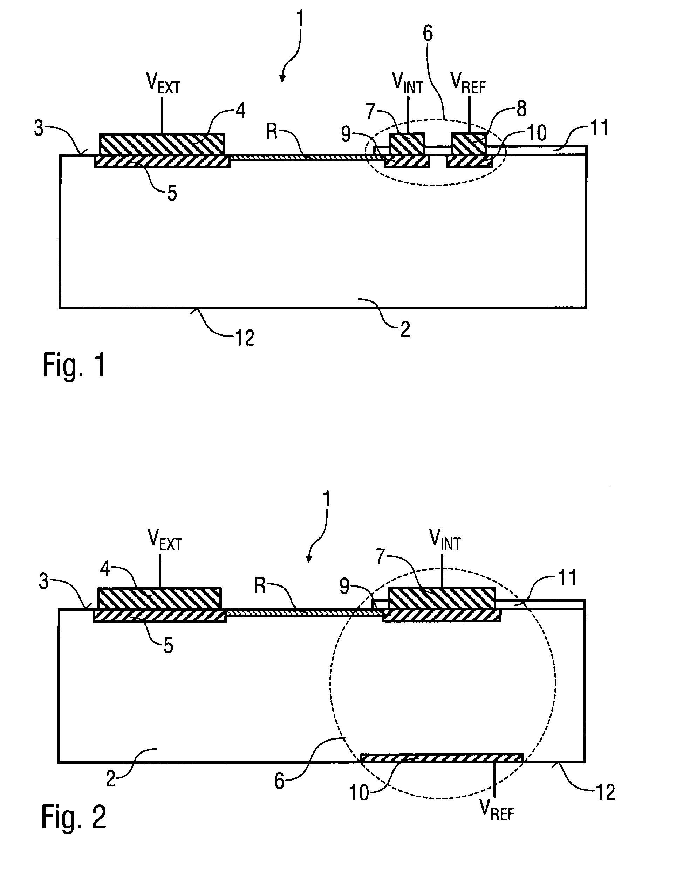

Figur 1 zeigt eine vereinfachte Querschnittsansicht eines erfindungsgemäßen Strahlungsdetektors 1, wobei die Darstellung auf die erfindungswesentlichen Einzelheiten beschränkt ist, so dass ansonsten auf die bereits eingangs erwähnten Veröffentlichungen zur Beschreibung derartiger Strahlungsdetektoren 1 verwiesen wird.

Der Strahlungsdetektor 1 weist ein Halbleitersubstrat 2 auf, das in diesem Ausführungsbeispiel n-dotiert ist, wobei die zu detektierende Strahlung in dem Halbleitersubstrat 2 Signalelektronen generiert, die ein Maß vor die einfallende Strahlung bilden.

An einer Vorderseite 3 des Halbleitersubstrats 2 befindet sich ein Anschlusskontakt 4 in Form eines Bond-Pads zur Zuführung der zu begrenzenden externen Spannung V_{EXT}. Unter dem Anschlusskontakt 4 befindet sich ein p-dotiertes Gebiet 5, das an der Vorderseite 3 des Halbleitersubstrats in das Halbleitersubstrat 2 eingelassen ist.

Darüber hinaus weist der Strahlungsdetektor 1 eine Punch-Through-Struktur 6 auf, die in der Querschnittszeichnung gestrichelt umrandet ist.

Die Punch-Through-Struktur 6 dient zur Begrenzung der externen Spannung V_{EXT}, die an dem Anschlusskontakt 4 anliegt. Hierzu weist die Punch-Through-Struktur 6 zwei Anschlusskontakte 7, 8 auf, die an der Vorderseite 3 des Strahlungsdetektors 1 angeordnet sind, wobei an dem Anschlusskontakt 7 eine spannungsbegrenzte interne Spannung V_{INT} bereitgestellt wird, während der Anschlusskontakt 8 zur Zuführung eines Referenzpotentials V_{REF} dient. Die Punch-Through-Struktur 6 begrenzt also die Spannungsdifferenz zwischen der externen Spannung V_{EXT} und dem Referenzpotential V_{REF}, so dass sich die maximal zulässige Spannung einstellen lässt, indem das an dem Anschlusskontakt 8 anliegende Referenzpotential V_{REF} entsprechend variiert wird.

Darüber hinaus weist die Punch-Through-Struktur 6 zwei stark p-dotierte Gebiete 9, 10 auf, die an der Vorderseite 3 in das Halbleitersubstrat 2 eingelassen sind, wobei die beiden dotierten Gebiete 9, 10 in lateraler Richtung voneinander beabstandet sind. Die Punch-Through-Spannung zwischen den beiden dotierten Gebieten 9, 10 der Punch-Through-Struktur 6 wird hierbei zum einen durch deren Abstand und zum anderen durch die Dotierungsstärke in dem Bereich dazwischen bestimmt. Es besteht deshalb die Möglichkeit, die Dotierungsstärke in dem Bereich zwischen den beiden dotierten Gebieten 9, 10 der Punch-Through-Struktur 6 beispielsweise durch eine gezielte Phosphorimplantation zu erhöhen, um eine entsprechend höhere Punch-Through-Spannung zu erreichen.

Die Punch-Through-Struktur 6 ist mit dem Anschlusskontakt 4 für die externe Spannung V_{EXT} durch einen Wiederstand R verbunden, der ebenfalls in das Halbleitersubstrat 2 integriert ist. Bei einer Überspannung an dem Anschlusskontakt 4 fällt also ein Teil der Überspannung über dem Widerstand R ab.

Schließlich ist noch zu erwähnen, dass an der Vorderseite 3 des Halbleitersubstrats 2 eine Oxidschicht 11 vorgesehen ist, über die die begrenzte Spannung V_{INT} dem Strahlungsdetektor 1 zugeführt werden kann, wobei die Oxidschicht 11 den Bereich des Widerstands R und den Bereich des Anschlusskontakts 4 ausspart, um eine Beschädigung der Oxidschicht 11 durch eine an dem Anschlusskontakt 4 möglicherweise anliegende Überspannung der externen Spannung V_{EXT} zu vermeiden.

Das Ausführungsbeispiel gemäß Figur 2 stimmt weitgehend mit dem vorstehend beschriebenen Ausführungsbeispiel gemäß Figur 1 überein, so dass zur Vermeidung von Wiederholungen auf die vorstehende Beschreibung verwiesen wird, wobei für entsprechende Einzelheiten dieselben Bezugszeichen verwendet werden.

Ein Unterschied dieses Ausführungsbeispiels besteht darin, dass die Punch-Through-Struktur 6 nicht - wie in Figur 1 - lateral angeordnet ist, sondern vertikal. Dies bedeutet, dass das dotierte Gebiet 9 an der Vorderseite 3 des Halbleitersubstrats 2 angeordnet ist, wohingegen sich das andere dotierte Gebiet 10 der Punch-Through-Struktur 6 an einer Rückseite 12 des Halbleitersubstrats 2 befindet. Auch hier lässt sich die Punch-Through-Spannung durch zusätzliche oberflächennahe Dotierungen verändern.

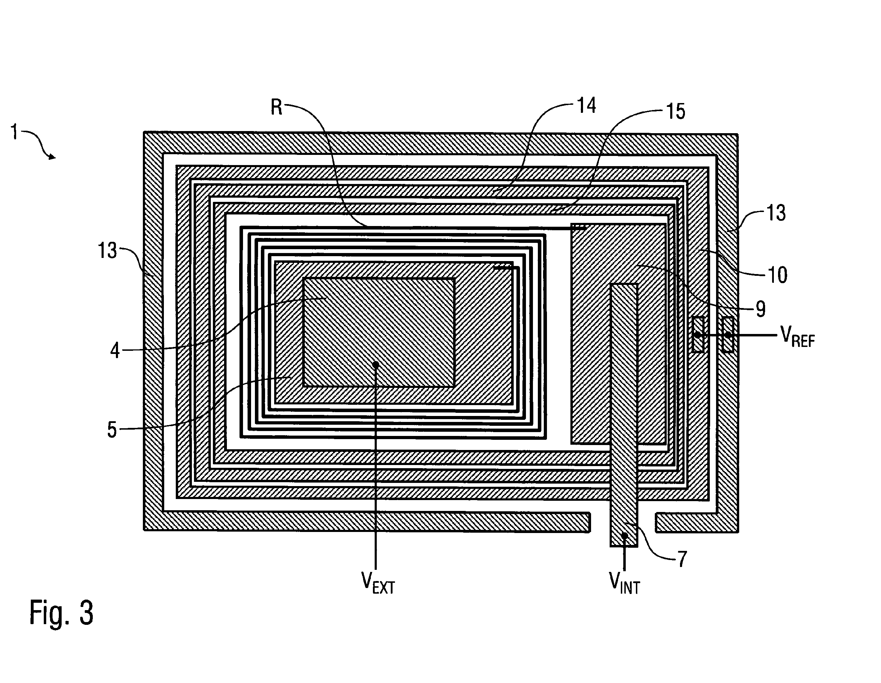

Das Ausführungsbeispiel gemäß Figur 3 stimmt weitgehend mit dem vorstehend beschriebenen Ausführungsbeispiel gemäß Figur 1 überein, so dass zur Vermeidung von Wiederholungen auf die vorstehende Beschreibung verwiesen wird, wobei für entsprechende Einzelheiten dieselben Bezugszeichen verwendet werden.

Hierbei umgibt die Schutzstruktur jedoch ein n⁺-dotierter Schutzring 13, wobei der Schutzring 13 mit dem äußeren dotierten Gebiet 10 der Punch-Through-Struktur leitend verbunden ist, so dass das Referenzpotential V_{REF} gleich dem Substratpotential ist.

Darüber hinaus weist der Überspannungsschutz zwischen dem äußeren dotierten Gebiet 10 für das Referenzpotential V_{REF} und dem inneren dotierten Gebiet 9 für die interne Spannung V_{INT} zusätzlich zwei p-dotierte Ringe 14, 15 auf, die jeweils durch schmale Abstände voneinander getrennt sind. Der Überspannungsschutz weist also in diesem Ausführungsbeispiel drei Punch-Through-Strukturen auf, die elektrisch hintereinander geschaltet sind, um zusammen eine höhere Punch-Through-Spannung zu erreichen.

Der anschließende p-dotierte Widerstand R ist spiralförmig um das p⁺-dotierte Gebiet 5 herumgewickelt und mit diesem verbunden. Damit wird die Überspannung kontinuierlich von innen nach außen abgebaut.

In dem inneren Bereich ist die vorstehend erwähnte Isolationsschicht (Oxidschicht) geöffnet, was auch für die anderen Verbindungen zwischen p⁺- und n⁺-Implantationen mit dem Metall gilt.

Schließlich ist die gesamte Schutzstruktur mit einer zusätzlichen tiefen n-Implantation unterlegt.

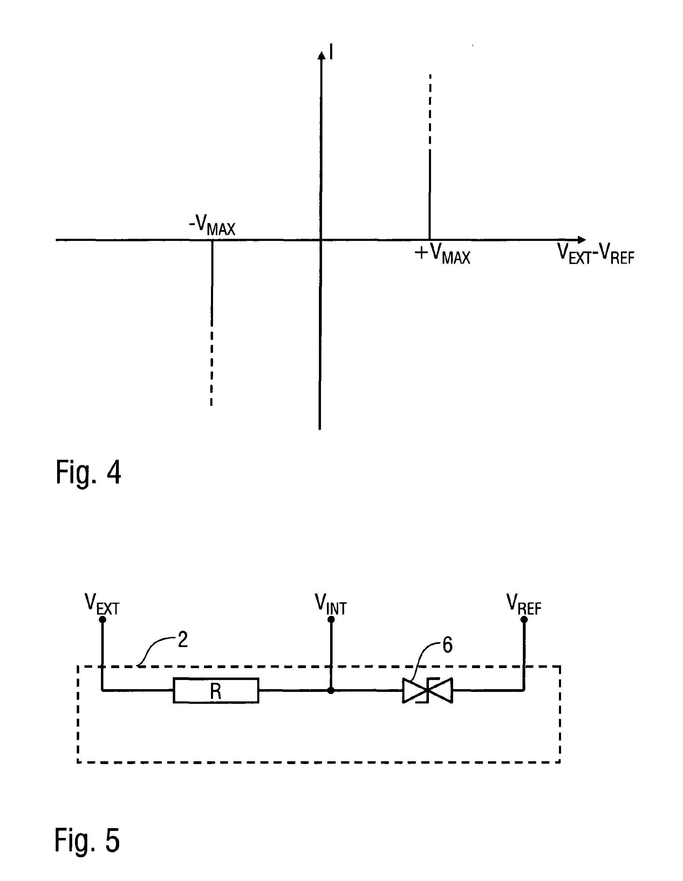

Figur 4 zeigt qualitativ und exemplarisch eine Strom-Spannungskennlinie der Punch-Through-Struktur 6. Daraus ist ersichtlich, dass die Punch-Through-Struktur 6 beim Überschreiten einer bestimmten Punch-Through-Spannung V_{MAX} vom sperrenden Zustand in den leitenden Zustand übergeht und damit einen weiteren Spannungsanstieg verhindert.

Schließlich zeigt Figur 5 ein vereinfachtes Ersatzschalbild des erfindungsgemäßen Überspannungsschutzes.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen. Darüber hinaus beansprucht die Erfindung auch Schutz für den Gegenstand der Unteransprüche unabhängig von dem Gegenstand und den Merkmalen der in Bezug genommenen Ansprüche.

### Bezugszeichenliste:

- 1: Strahlungsdetektor
- 2: Halbleiter
- 3: Vorderseite
- 4: Anschlusskontakt
- 5: Dotiertes Gebiet
- 6: Punch-Through-Struktur
- 7: Anschlusskontakt
- 8: Anschlusskontakt
- 9: Dotiertes Gebiet
- 10: Dotiertes Gebiet
- 11: Oxidschicht
- 12: Rückseite
- 13: Schutzring
- 14: p-dotierter Ring
- 15: p-dotierter Ring
- R: Widerstand
- V_{EXT}: Externe Spannung
- V_{INT}: Interne Spannung
- U_{REF}: Referenzpotential

## Patentansprüche

1. Halbleiterbauelement (1), insbesondere Strahlungsdetektor (1) zur Detektion von Strahlung, mit
a) einem Halbleitersubstrat (2), insbesondere einem Halbleitersubstrat (2), in dem die zu detektierende Strahlung Signalladungsträger generiert, und
b) einem Überspannungsschutz zur Vermeidung von elektrischen Überspannungen,
**dadurch gekennzeichnet,**
c) **dass** der Überspannungsschutz (6) in das Halbleitersubstrat (2) integriert ist.

2. Halbleiterbauelement (1) nach Anspruch 1,
**dadurch gekennzeichnet,**
a) **dass** der Überspannungsschutz (6) ein Schutzelement mit einer nicht-linearen Strom-Spannungs-Kennlinie mit einer bestimmten Durchbruchspannung (+V_{MAX}, -V_{MAX}) aufweist, wobei das Schutzelement (6) unterhalb der Durchbruchspannung (+V_{MAX}, -V_{MAX}) im Wesentlichen sperrt und oberhalb der Durchbruchspannung (+V_{MAX}, -V_{MAX}) im Wesentlichen leitet, und/oder
b) **dass** die Strom-Spannungs-Kennlinie des Schutzelements (6) eine positive Durchbruchspannung (+V_{MAX}) und eine negative Durchbruchspannung (-V_{MAX}) aufweist.

3. Halbleiterbauelement (1) nach Anspruch 1 oder 2,
**gekennzeichnet durch**
a) einen ersten Anschlusskontakt (4) zur Zuführung einer zu begrenzenden externen Spannung (V_{EXT}), und
b) einen zweiten Anschlusskontakt (7) zur Bereitstellung einer spannungsbegrenzten internen Spannung (V_{INT}), wobei der Überspannungsschutz (6) die interne Spannung (V_{INT}) vor einer Überspannung der externen Spannung (V_{EXT}) schützt, und/oder
c) einen dritten Anschlusskontakt (8) zur Bereitstellung eines Referenzpotentials (V_{REF}), wobei der Überspannungsschutz (6) die zu begrenzende externe Spannung (V_{EXT}) gegenüber dem Referenzpotential (V_{REF}) begrenzt.

4. Halbleiterbauelement (1) nach Anspruch 3,
**dadurch gekennzeichnet,**
a) **dass** der Überspannungsschutz (6) zwischen den zweiten Anschlusskontakt (7) für die interne Spannung (V_{INT}) und den dritten Anschlusskontakt (8) für die Referenzspannung (V_{REF}) geschaltet ist, und/oder
b) **dass** ein Widerstand (R) zwischen den ersten Anschlusskontakt (4) für die externe Spannung (V_{EXT}) und den zweiten Anschlusskontakt (7) für die interne Spannung (V_{INT}) geschaltet ist, so dass ein Teil der Überspannung über dem Widerstand (R) abfällt.

5. Halbleiterbauelement (1) nach Anspruch 4,
**dadurch gekennzeichnet,**
a) **dass** der Widerstand (R) in das Halbleitersubstrat (2) integriert ist, und/oder
b) **dass** der Widerstand (R) in dem Halbleitersubstrat (2) mindestens teilweise spiralförmig oder mäanderförmig verläuft.

6. Halbleiterbauelement (1) nach einem der vorhergehenden Ansprüche, **dadurch gekennzeichnet,**
a) **dass** der integrierte Überspannungsschutz eine Punch-Through-Struktur (6) aufweist, die in das Halbleitersubstrat (2) integriert ist, oder
b) **dass** der Überspannungsschutz eine Zener-Diode, eine Suppressor-Diode oder eine Avalanche-Diode aufweist, die in das Halbleitersubstrat (2) integriert ist.

7. Halbleiterbauelement (1) nach Anspruch 6,
**dadurch gekennzeichnet,**
a) **dass** die Punch-Through-Struktur (6) in der Halbleitersubstrat (2) vertikal angeordnet ist und sich zwischen gegenüberliegenden Oberflächen (3, 12) des Halbleitersubstrats (2) erstreckt, oder
b) **dass** die Punch-Through-Struktur (6) in dem Halbleitersubstrat (2) lateral angeordnet ist und sich entlang derselben Oberfläche (3) des Halbleitersubstrats (2) erstreckt, und/oder
c) **dass** die Punch-Through-Struktur ringförmig oder linear ist.

8. Halbleiterbauelement (1) nach einem der vorhergehenden Ansprüche, **dadurch gekennzeichnet,**
a) **dass** das Halbleitersubstrat (2) entsprechend einem ersten Dotierungstyp (n) dotiert ist, und
b) **dass** die Punch-Through-Struktur (6) ein erstes dotiertes Gebiet (10) aufweist, das entsprechend einem zweiten Dotierungstyp (p⁺) dotiert und in das Halbleitersubstrat (2) eingelassen ist, und
c) **dass** die Punch-Through-Struktur (6) ein zweites dotiertes Gebiet (9) aufweist, das entsprechend dem zweiten Dotierungstyp (p⁺) dotiert und in das Halbleitersubstrat (2) eingelassen ist, wobei das erste dotierte Gebiet (10) von dem zweiten dotierten Gebiet (9) beabstandet ist, und/oder
d) **dass** das erste dotierte Gebiet (10) der Punch-Through-Struktur das zweite dotierte Gebiet (9) der Punch-Through-Struktur ringförmig umgibt.

9. Halbleiterbauelement (1) nach einem der Ansprüche 6 bis 8, **dadurch gekennzeichnet,**
a) **dass** der erste Anschlusskontakt (4) für die externe Spannung (V_{EXT}) als Bond-Pad ausgebildet ist, und/oder
b) **dass** der erste Anschlusskontakt (4) für die externe Spannung (V_{EXT}) mit einem dritten dotierten Gebiet (5) verbunden ist, wobei das dritte dotierte Gebiet (5) entsprechend dem zweiten Dotierungstyp (p) dotiert und in das Halbleitersubstrat (2) eingelassen ist, und/oder
c) **dass** das dritte dotierte Gebiet (5) an derselben Oberfläche (3) des Halbleitersubstrats (2) angeordnet ist wie das zweite dotierte Gebiet (9) der Punch-Through-Struktur (6).

10. Halbleiterbauelement (1) nach einem der vorhergehenden Ansprüche, **dadurch gekennzeichnet,**
a) **dass** das Halbleitersubstrat (2) an der Oberfläche (3) mit dem ersten Anschlusskontakt (4) für die externe Spannung (V_{EXT}) eine Oxidschicht (11) aufweist, und
b) **dass** die Oxidschicht (11) den Bereich des ersten Anschlusskontakts (4) für die externe Spannung (V_{EXT}) und/oder den Bereich des Widerstands (R) ausspart, um eine Schädigung der Oxidschicht (11) durch die externe Spannung (V_{EXT}) zu vermeiden, oder
c) **dass** sich die Oxidschicht (11) auch in den Bereich des ersten Anschlusskontakts (4) für die externe Spannung (V_{EXT}) und/oder des Widerstands (R) erstreckt, wobei der erste Anschlusskontakt (4) für die externe Spannung (V_{EXT}) das in das Halbleitersubstrat (2) eingelassene dritte dotierte Gebiet (5) kontaktiert, insbesondere durch die Oxidschicht (11) hindurch.

11. Halbleiterbauelement (1) nach einem der vorhergehenden Ansprüche, **dadurch gekennzeichnet, dass** das Halbleitersubstrat (2) zwischen den dotierten Bereichen (9, 10) der Punch-Through-Struktur (6) eine zusätzliche Dotierung, insbesondere in Form einer Phosphor-Implantation, aufweist, um die Dotierungsstärke und damit auch die Punch-Through-Spannung zu erhöhen.

12. Halbleiterbauelement (1) nach einem der vorhergehenden Ansprüche, **dadurch gekennzeichnet,**
a) **dass** der Überspannungsschutz mehrere Punch-Through-Strukturen (6) aufweist, die elektrisch hintereinander geschaltet sind, um eine höhere Punch-Through-Spannung zu erreichen, und/oder
b) **dass** die verschiedenen Punch-Through-Strukturen (6) jeweils ringförmig sind und/oder im Wesentlichen konzentrisch angeordnet sind.
